# EUROPEAN PATENT SPECIFICATION

(11) **EP 0 420 508 B1**
(45) Date of publication and mention of the grant of the patent: **31.07.1996**
(21) Application number: 90310315.8
(22) Date of filing: 20.09.1990
(51) Int. Cl.: H03J 3/04, H04Q 7/32

(54) **Logic controlled adjustment and compensation of signal levels and deviations in a radio telephone**
Digital gesteuerte Anpassung und Ausgleich von Signalpegeln und Abweichungen in einem Funktelefon
Commande numérique d'ajustement et de compensation des niveaux et déviations du signal dans un radio téléphone

(30) Priority: 25.09.1989 FI 894527
(43) Date of publication of application: 03.04.1991
(73) Proprietor: NOKIA MOBILE PHONES LTD., SF-24101 Salo (FI)
(72) Inventor: Vaisanen, Risto, SF-24100 Salo (FI); Leppanen, Aki, SF-24260 Salo (FI)
(74) Representative: Singleton, Jeffrey

(56) References cited:
- EP-A- 0 369 135
- EP-A- 0 376 666
- EP-A- 0 420 505
- EP-A- 0 420 506
- EP-A- 0 420 507
- GB-A- 2 194 696
- PATENT ABSTRACTS OF JAPAN vol. 14, no. 362 (E-96)6 August 1990 & JP-A-2 126 735

## Description

The invention relates to a logic controlled method of adjusting signals and/or deviations in a radio telephone having a logic section which controls the operation, and to the use of this method in series production and maintenance. The invention also relates to an adjustment system for a radio telephone, which is adjusted with a method according to the invention.

A method for the setting of electronic circuits can be found in EP-A-376666 (published on 4/7/90) which represents State of the Art acc. to Art 54(3), EPC.

In a radio telephone there are certain signals, whose levels and deviations have to be kept within the adjusted value in all conditions, independent of temperature. These signals include for example the low frequency level of the receiver, the deviation of the transmitter or of the control signal, etc. The signals pass through e.g. amplifiers, filters, detector circuits, mixers and modulators. Due to temperature there will occur changes of the amplification or the deviation in all of these stages. The most common approach in prior art is to accept these changes, and to compensate them by temperature dependent resistances.

However, it has proved to be a poor solution to use temperature-dependent resistances (NTC- and PTC-resistors), because some circuits, e.g. filters and detector circuits behave individually in different temperatures, and it is not possible to fully predict the changes. The variations of the compensating component tolerances also have a substantial effect on the changes.

Up to now a known solution was to accept a poorer yield in production, or to use better components. The first alternative leads to increased production costs. The latter alternative leads to increased costs, and moreover, the size and power consumption of such components could be substantially bigger, and thus it is not possible to use them in small sized handsets.

The object of the invention is to devise a method, with which the above mentioned prior art problems and drawbacks are obviated.

The solution to the problem is achieved with the inventive method according to claim 1.

In the invention it is essential to store individual adjustment results for selected operating conditions into the radio telephone's memory as compensating values, whereby the respective signal (level and/or deviation) is controlled and corrected by the compensating constants in accordance to the tuning results by the logic controlled amplifier, when the radio telephone is in operation. Preferably the adjustment is made by connecting the adjusting equipment to the normal external connections of the radio telephone, the adjustment being made without opening the radio telephone casing.

This adjustment arrangement may be applied to the final testing in series production of radio telephones, and to the maintenance of radio telephones.

The adjustment system as set out in claim 6 of set A and in claim 5 of set B, according to the invention comprises a radio telephone which includes sensors connected to the logic section and detecting the radio telephone's operating conditions, and in the signal path is arranged a logic controlled amplifier, which amplifies the signal in accordance to data corrected with a compensating constant corresponding to the operating conditions and supplied by the logic.

Other preferred embodiments of the invention are presented in the subclaims.

The invention is described in more detail by way of an example with reference to the accompanying drawing, in which:
- figure 1: is a simplified block diagram illustrating the adjusting arrangement according to the invention; and
- figure 2: presents a circuit diagram of a logic controlled amplifier in a radio telephone according to the invention.

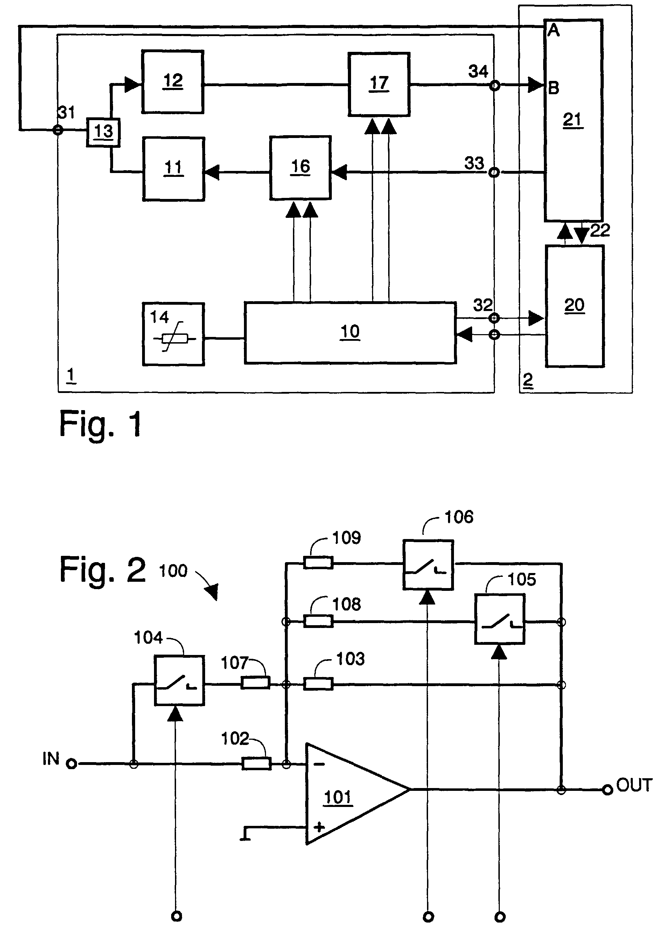

Referring to figure 1 the adjusting equipment 2 is connected to the radio telephone's 1 antenna interface 31 and auxiliary equipment interface 32 including the low frequency interfaces 33, 34. The test signal selected for the adjustment (e.g. a constant microphone voltage or sound pressure to the microphone) is connected from the measuring device 21 of the adjusting equipment 2 to the radio telephone interfaces 31 or 33. The measuring computer 20 of the adjusting equipment is connected to the radio telephone's logic section 10 through the auxiliary interface 32. The measuring computer 20 can via the logic section 10 control the radio telephone to select a desired channel (radio frequency). Through the logic section 10 it can also control the logic controlled amplifiers 16, 17, which adjusts the level and/or deviation of the signal to be adjusted.

The test signal can be connected to the low frequency interface 33, whereby the modulating audio signal (which normally comes from the microphone) is amplified with the logic controlled amplifier 16 and then connected as the output power of the transmitter 11 to the antenna interface 31, e.g. through a duplex filter 13, and it will be measured with measuring devices 21, the measuring result of which is transmitted on an internal bus 22 to the measuring computer 20.

In the other transmission direction the radio frequency test signal from the measuring devices 21 is directed to the antenna interface 31. To the antenna interface 31 is connected the radio telephone receiver 12, which supplies an audio signal that is amplified in a logic controlled amplifier 17, and the result (in normal operation directed to the earphone) is measured with the measuring devices 21 through the interface 34 and transmitted on an internal bus 22 to the measuring computer 20.

The radio telephone also includes a temperature sensor 14 to detect the internal temperature of the radio telephone.

The logic section 10 i.a. also includes a microprocessor, memories - especially a non-volatile memory to store programs and compensating data - and an A/D-converter, with which the operating temperature of the batteries or accumulators and the voltage from the temperature sensor 14 is converted into a digital format which can be used by the microprocessor. During adjustment the microprocessor is connected to the measuring computer 20 via the auxiliary equipment interface 32, through which information is exchanged in both directions, e.g. information about the temperature measured by the sensor 14 to the measuring computer and set values from the measuring computer to the microprocessor.

The operating channel (or channel range) and the temperature (or temperature range) measured by the sensor 14 constitute the operating conditions of the radio telephone.

The adjustment of the radio telephone according to the invention is carried out in the following manner. The adjustment is initially made at room temperature. The radio telephone is placed in a climate chamber (cold/hot chamber), and the measuring devices 21 are connected to the antenna interface 31 and the low frequency interfaces 33, 34.
1) Information about the signal (level or deviation) to be adjusted and a set value is connected from the measuring computer 20 via the auxiliary interface 32 to the microprocessor 10. The logic section 10 of the radio telephone 1 controls the logic controlled amplifier so that the target value of the signal to be adjusted is reached with a selected, sufficient precision. The modulation sensitivity is adjusted at room temperature as a function of the selected channels. The deviation is measured on the middle channel, and on the extreme channels the deviations are checked (in several parts) and the deviations from the value of the middle channel are stored as compensating factors in the non-volatile memory of the microprocessor 10. In operation these calculated compensating factors, or values measured on the extreme channels, are used by the radio telephone software for the respective channels.
2) The temperature of the climate chamber is changed to the minimum temperature to be tested (e.g. -25 °C). When the temperature sensor 14 has determined that the desired internal temperature is achieved, the adjustment of step 1) is repeated. The obtained adjustment values are used by the radio telephone below a certain temperature.
3) The temperature of the climate chamber is changed to the maximum operating temperature (e.g. +55 °C), and the same procedure as for step 2) is repeated. The obtained adjustment values are used by the radio telephone above a certain temperature.

It is possible to automate the steps 2) and 3) so that the mean adjustment values in cold and hot of the previous telephones (in series production) are stored in the memory of the measuring computer 20. The adjustment of the telephone to be adjusted is started in the respective step with set values in accordance with these mean values, and then the measurement (levels and deviations) is performed. If any signal to be measured deviates from the adjustment value, exceeding an acceptable limit value, the measuring computer 20 will repeat the adjustment at the temperature in question, after which the adjustment values are stored into the radio telephone memory.

It should be noted that the adjustment may also be carried out with operating conditions in an order differing from the above order, depending on the available climate chamber arrangement and other productions reasons. The number of operating conditions to be adjusted may be chosen to suit the production and the operation of the radio telephone. The number of the operating conditions can be reduced in a convenient way by using e.g. only one adjustment point representing a middle range, a higher range and a lower range, respectively, for each variable (channel, temperature). For example, in practice the ranges could be:
- a middle channel representing a middle range, the highest and the lowest channel representing the higher and the lower ranges; and correspondingly
- room temperature (e.g. 25 °C for the range +5...+45 °C), maximum temperature (e.g. +55 °C for the range +45...+85 °C) and minimum temperature (e.g. -10 °C for the range -25...+5 °C).

In the production the adjustment can be made in the final testing, when the radio telephone is otherwise completely ready. The adjustment can now be made without opening the telephone's casing. Furthermore, by suitable programming of the steps 1) to 3) in the measuring computer, the adjustment can be made completely automatically, whereby the results of the adjustment will become more reliable (no human errors). Due to the automation the testing throughput time and the amount of required personnel will be reduced. From a production management standpoint the inventive method signifies a great advantage, when for example the production is transferred to another plant, because the automatic adjustment program does not require much training of personnel for the adjustment tasks, as all information required in the adjustment can be incorporated in the tuning programs of the measuring computer.

The adjustment method according to the invention can also conveniently be used in the maintenance of radio telephones, whereby the adjusting equipment may be replaced by simpler service equipment, with which e.g. the adjustment of the radio telephone is checked, and/or the adjustment is made only at room temperature. Then the measuring of the signals and the storing of adjustment results will be carried out in the same way as in automatic adjustment, but the person performing the adjustment will calculate the compensating constants or factors and decide on the adjustment result. In a radio telephone realizing the method according to the invention the temperature during operating is measured with a sensor 14 and A/D-converters (not shown). In accordance with the operating conditions the microprocessor 10 selects from its non-volatile memory a relevant compensating constant or a set value adjusted for the operating conditions, and the amplification of the logic controlled amplifiers is set according to this value.

Figure 2 shows circuit diagram of a logic controlled amplifier 100 (reference numerals 16, 17 in figure 1) used in a radio telephone according to the invention. The amplifier 100 comprises an operational amplifier 101, feed-back resistors 102 and 103, and analog switches 104, 105 and 106. With the analog switches 104, 105 and 106, controlled by the microprocessor 10 (not shown), a desired combination of other feed-back resistors 107, 108 and 109 can be connected in parallel with the main feed-back resistors 102 and 103. In the example of figure 2 three switchable resistors are used, whereby the total number of the switchable amplification steps is 8. The number of the switchable resistors can of course be selected in accordance with the number of required amplification steps (the number of amplification steps = 2^{N}, where N is the number of the switchable resistors).

No analog compensating circuits are required in the radio telephone according to the invention, and thus the number of components is reduced. It is further possible to allow larger tolerance values for the components, because it is possible to perform a temperature compensation individually for every radio telephone. Thus the yield of the production will increase. The achieved compensations will also be more accurate, because the compensating components will not affect the compensation results. At the same time a saving in circuit board area is achieved.

The invention can be applied to different types of analog and digital radio telephones, cellular radio telephones, portable and mobile radio telephones.

## Claims (Claims for the following Contracting State(s): DK, LU, AT, ES, GR)

1. A logic controlled method of adjusting a radio telephone having a logic section (10) which controls its operation, characterised in that
- an external adjusting equipment (2) is connected to the antenna interface (31), low frequency interfaces (33, 34) and to an auxiliary interface (32) or to corresponding interfaces of the radio telephone,
- a test signal is applied from the adjusting equipment (2) via the antenna interface (31) or a low frequency interface (33) to the radio telephone
- an output signal (A,B) from the radio telephone resulting from application of the test signal is measured via one of the interfaces (31, 34) by the adjusting equipment (2) and adjustment made in a feed-back loop (2, 32, 1, 31; 2, 32, 1, 34) via the logic section (10) until the desired power level of the output signal (A,B) is achieved,
- the individual adjustment results made for the radio telephone are stored as compensating constants or values in a non-volatile memory arranged in the logic section (10),
- whereby the respective output signal (A,B), level and/or deviation, is controlled through the logic controlled amplifier (16, 17) corrected in accordance with the adjustment results stored in the logic section (10), when the radio telephone (1) is in operation.

2. A method according to claim 1, characterised in that the adjustment can be made without opening the radio telephone (1) casing.

3. A method according to Claim 1 or 2, characterised in that in the adjusting equipment (2) there is arranged a measuring device (21) for the output signals (A,B) to be adjusted and a computer (20) with a stored program and stored target values for the output signal (A,B), level and/or deviation, according to which the adjustment is performed, optionally either as automatic or semiautomatic adjustment.

4. A method according to any previous claim, wherein the adjustment is made sequentially for several channels or channel ranges and for one or more operating temperature ranges, whereby the adjustment equipment receives information about the radio telephone operating conditions through the logic section (10) and the auxiliary equipment interface (32) and whereby every adjustment result is stored as a compensating value into the non-volatile memory of the radio telephone's logic section (10).

5. A procedure for adjusting radio telephones in series production employing a method according to Claim 3 or 4 so that in adjusting a radio telephone of the series the computer (20) supplies to the logic section (10) of the radio telephone, as a first set value the long-time mean value of the set values corresponding to the adjustment results of previously tuned telephones.

6. An adjustment system for a radio telephone comprising a radio telephone and an external adjustment equipment, said radio telephone comprising an antenna interface (31), first and second low frequency interfaces (33, 34) and an auxiliary interface (32) or corresponding interfaces, a logic section (10) which controls operation of the radio telephone the logic section (10) having a non-volatile memory, amplifiers (16,17) controlled by the logic section (10) to amplify, respectively, signals from the first low frequency interface (33) and the antenna interface (31), and a sensor (14) detecting the radio telephone's operating conditions connected to the logic section (10) the radio telephone being so constructed and arranged that signals applied via the first low frequency interface (33) or the antenna interface (31) are amplified by the amplifiers (16,17) in accordance with adjustment results stored in the non-volatile memory of the logic section (10) the external adjustment equipment being connected to the antenna interface, the low frequency interface, an auxiliary interface or corresponding interfaces of said radio telephone, and comprising:
- a device (21) for applying a test signal to the radio telephone via said interfaces and to measure an output signal of the radio telephone resulting from the application of said test signal, and
- measuring computer (20) for adjusting said output of the radio telephone in a feed-back loop via said interfaces until a desired power level of said output signal is achieved.

7. An adjustment system according to claim 6, wherein the logic section (10) of the radio telephone comprises a microprocessor.

8. An adjustment system according to Claim 6 or 7, wherein the sensors (10, 14) of the radio telephone detecting the operating conditions comprise a device (10) detecting the operating channel or channel range and a temperature sensor (14).

9. An adjustment system according to any one of Claims 6 to 8, wherein the logic controlled amplifier (100; 16, 17) of the radio telephone consists of an operational amplifier (101), feed-back resistors (102, 103, 107 - 109), analog switches (104 - 106), which controlled by the logic section (10) connect in parallel the feed-back resistors (107 - 109) into the feed-back path producing the desired amplification.

## Claims (Claims for the following Contracting State(s): BE, CH, DE, FR, GB, IT, LI, NL, SE)

1. A logic controlled method of adjusting a radio telephone having a logic section (10) which controls its operation, characterised in that
- an external adjusting equipment (2) is connected to the antenna interface (31), low frequency interfaces (33, 34) and to an auxiliary interface (32) or to corresponding interfaces of the radio telephone,
- a test signal is applied from the adjusting equipment (2) via the antenna interface (31) or a low frequency interface (33) to the radio telephone
- an output signal (A,B) from the radio telephone resulting from application of the test signal is measured via one of the interfaces (31, 34) by the adjusting equipment (2) and adjustment made in a feed-back loop (2, 32, 1, 31; 2, 32, 1, 34) via the logic section (10) until the desired power level of the output signal (A,B) is achieved,
- the individual adjustment results made for the radio telephone are stored as compensating constants or values in a non-volatile memory arranged in the logic section (10),
- whereby the respective output signal (A,B), level and/or deviation, is controlled through the logic controlled amplifier (16, 17) corrected in accordance with the adjustment results stored in the logic section (10), when the radio telephone (1) is in operation and wherein the adjustment is made sequentially for several channels or channel ranges and for one or more operating temperature ranges, whereby the adjustment equipment receives information about the radio telephone operating conditions through the logic section (10) and the auxiliary equipment interface (32) and whereby every adjustment result is stored as a compensating value into the non-volatile memory of the radio telephone's logic section (10).

2. A method according to claim 1, characterised in that the adjustment can be made without opening the radio telephone (1) casing.

3. A method according to Claim 1 or 2, characterised in that in the adjusting equipment (2) there is arranged a measuring device (21) for the output signals (A,B) to be adjusted and a computer (20) with a stored program and stored target values for the output signal (A,B), level and/or deviation, according to which the adjustment is performed, optionally either as automatic or semiautomatic adjustment.

4. A procedure for adjusting radio telephones in series production employing a method according to Claim 3 so that in adjusting a radio telephone of the series the computer (20) supplies to the logic section (10) of the radio telephone, as a first set value the long-time mean value of the set values corresponding to the adjustment results of previously tuned telephones.

5. An adjustment system for a radio telephone comprising a radio telephone and an external adjustment equipment, said radio telephone comprising an antenna interface (31), first and second low frequency interfaces (33, 34) and an auxiliary interface (32) or corresponding interfaces, a logic section (10) which controls operation of the radio telephone the logic section (10) having a non-volatile memory, amplifiers (16,17) controlled by the logic section (10) to amplify, respectively, signals from the first low frequency interface (33) and the antenna interface (31), and a sensor (14) detecting the radio telephone's operating conditions connected to the logic section (10) the radio telephone being so constructed and arranged that signals applied via the first low frequency interface (33) or the antenna interface (31) are amplified by the amplifiers (16,17) in accordance with adjustment results stored in the non-volatile memory of the logic section (10) tuned in accordance with the method of any previous claim; the external adjustment equipment being connected to the antenna interface, the low frequency interface, an auxiliary interface or corresponding interfaces of said radio telephone, and comprising:
- a device (21) for applying a test signal to the radio telephone via said interfaces and to measure an output signal of the radio telephone resulting from the application of said test signal, and
- a measuring computer (20) for adjusting said output of the radio telephone in a feed-back loop via said interfaces until a desired power level of said output signal is achieved and for sequentially selecting several channels or channel ranges and one or more operating temperature ranges of the radio telephone.

6. An adjustment system according to Claim 5, wherein the logic section (10) of the radio telephone comprises a microprocessor.

7. An adjustment system according to Claim 5 or 6, wherein the sensors (10, 14) of the radio telephone detecting the operating conditions comprise a device (10) detecting the operating channel or channel range and a temperature sensor (14).

8. An adjustment system according to any one of Claims 5 to 7, wherein the logic controlled amplifier (100; 16, 17) of the radio telephone consists of an operational amplifier (101), feed-back resistors (102, 103, 107 - 109), analog switches (104 - 106), which controlled by the logic section (10) connect in parallel the feed-back resistors (107 - 109) into the feed-back path producing the desired amplification.

## Patentansprüche (Patentansprüche für folgende(n) Vertragsstaat(en): DK, LU, AT, ES, GR)

1. Logisch gesteuertes Verfahren zur Einstellung eines Funktelefons. das einen seinen Betrieb steuernden Logikteil (10) enthält, **dadurch gekennzeichnet**, daß
- eine externe Einstelleinrichtung (2) an den Antennenanschluß (31), die Niederfrequenzanschlüsse (33, 34) und an einen Zusatzanschluß (32) oder entsprechende Anschlüsse des Funktelefons angeschlossen wird.
- ein Testsignal von der Einstelleinrichtung (2) über den Antennenanschluß (31) oder einen Niederfrequenzanschluß (33) an das Funktelefon angelegt wird.
- ein Ausgangssignal (A, B) des Funktelefons, das durch das Anlegen des Testsignals erzeugt wurde, von der Einstelleinrichtung (2) über einen der Anschlüsse (31, 34) gemessen und die Einstellung mittels einer den Logikteil (10) enthaltenen Rückkopplungsschleife (2, 32, 1, 31; 2, 32, 1, 34) durchgeführt wird, bis der gewünschte Leistungspegel des Ausgangssignals (A. B) erreicht wird.
- die einzelnen Ergebnisse der Einstellung des Funktelefons als Kompensationskonstanten oder -werte in einem nichtflüchtigen Speicher des Logikteils (10) gespeichert werden, und
- der Pegel und/oder die Abweichung des jeweiligen Ausgangssignals (A, B) mittels eines logisch gesteuerten Verstärkers (16, 17) geregelt und in Übereinstimmung mit den im Logikteil (10) gespeicherten Ergebnissen der Einstellung korrigiert wird, wenn sich das Funktelefon (1) im Betriebszustand befindet.

2. Verfahren nach Anspruch 1, **dadurch gekennzeichnet,** daß die Einstellung durchgeführt wird, ohne das Gehäuse des Funktelefons (1) zu öffnen.

3. Verfahren nach Anspruch 1 oder 2, **dadurch gekennzeichnet**, daß die Einstelleinrichtung (2) ein Meßgerät (21) zur Messung der einzustellenden Ausgangssignale (A. B) und einen Computer (20) mit einem gespeicherten Programm und gespeicherten Referenzwerten des Pegels und/oder der Abweichung des Ausgangssignals (A, B) enthält, auf deren Grundlage die Einstellung wahlweise automatisch oder halbautomatisch durchgeführt wird.

4. Verfahren nach einem der vorhergehenden Ansprüche, **dadurch gekennzeichnet**, daß die Einstellung sequentiell für mehrere Kanäle oder Kanalbereiche und für einen oder mehrere Betriebstemperaturbereiche durchgeführt wird, wobei die Einstelleinrichtung Information über die Betriebsbedingungen des Funktelefons über den Logikteil (10) und den Anschluß für Zusatzgeräte (32) erhält, und wobei jedes Einstellergebnis als Kompensationswert im nichtflüchtigen Speicher des Logikteils (10) des Funktelefons gespeichert wird.

5. Verfahren zur Einstellung eines Funktelefons nach Anspruch 3 oder 4 bei einer Serienfertigung, **dadurch gekennzeichnet**, daß der Computer (20) bei der Einstellung eines Funktelefons einer Serie die Langzeit Mittelwerte des Satzes von Kompensationswerten der vorher abgestimmten Funktelefone als ersten Satz von Kompensationswerten in den Logikteil (10) des Funktelefons eingibt.

6. Vorrichtung zur Einstellung eines Funktelefons, mit einem Funktelefon und einer externen Einstelleinrichtung, wobei das Funktelefon einen Antennenanschluß (31); einen ersten und einen zweiten Niederfrequenzanschluß (33. 34) sowie einen Zusatzanschluß (32) oder entsprechende Anschlüsse; einen Logikteil (10), der den Betrieb des Funktelefons steuert und einen nichtflüchtigen Speicher enthält; vom Logikteil (10) gesteuerte Verstärker (16, 17) zur jeweiligen Verstärkung der Signale des ersten Niederfrequenzanschlusses (33) und des Antennenanschlusses (31); und einen an den Logikteil angeschlossenen Sensor (14) zum Detektieren der Betriebsbedingungen des Funktelefons aufweist, wobei das Funktelefon so aufgebaut und angeordnet ist, daß über den ersten Niederfrequenzanschluß (33) oder den Antennenanschluß (31) angelegte Signale durch die Verstärker (16, 17) in Übereinstimmung mit den in dem nichtflüchtigen Speicher des Logikteils (10) gespeicherten Ergebnissen der Einstellung verstärkt werden, und wobei die externe Einstelleinrichtung an den Antennenanschluß, den Niederfrequenzanschluß, einen Zusatzanschluß oder entsprechende Anschlüsse des Funktelefons angeschlossen ist und folgendes enthält:
- eine Vorrichtung (2 1) zum Anlegen eines Testsignals über diese Anschlüsse an das Funktelefon und zum Messen eines Ausgangssignals des Funktelefons. das durch das angelegte Testsignal erzeugt wurde, und
- einen Meßcomputer (20) zur Einstellung des Ausgangssignals des Funktelefons mittels einer Rückkopplungsschleife über die Anschlüsse, bis ein gewünschter Leistungspegel des Ausgangssignals erreicht ist.

7. Vorrichtung nach Anspruch 6, **dadurch gekennzeichnet**, daß der Logikteil (10) des Funktelefons einen Mikroprozessor enthält.

8. Vorrichtung nach Anspruch 6 oder 7, **dadurch gekennzeichnet**, daß die Sensoren (10, 14) des Funktelefons, die die Betriebsbedingungen detektieren, eine Vorichtung (10) zum Detektieren des Betriebskanals oder Kanalbereichs und einen Temperatursensor (14) aufweisen.

9. Vorrichtung nach einem der Ansprüche 6 bis 8, **dadurch gekennzeichnet**, daß der logisch gesteuerte Verstärker (100; 16, 17) des Funktelefons einen Operationsverstärker (101), Rückkopplungswiderstände (102, 103, 107 - 109) und Analogschalter (104 - 106) enthält, die von dem Logikteil (10) gesteuert die Rückkopplungswiderstände (107 - 109) parallel in den Rückkopplungszweig schalten, um die gewünschte Verstärkung zu erzeugen.

## Patentansprüche (Patentansprüche für folgende(n) Vertragsstaat(en): BE, CH, DE, FR, GB, IT, LI, NL, SE)

1. Logisch gesteuertes Verfahren zur Einstellung eines Funktelefons, das einen seinen Betrieb steuernden Logikteil (10) enthält, **dadurch gekennzeichnet**, daß
- eine externe Einstelleinrichtung (2) an den Antennenanschluß (31), die Niederfrequenzanschlüsse (33, 34) und an einen Zusatzanschluß (32) oder entsprechende Anschlüsse des Funktelefons angeschlossen wird,
- ein Testsignal von der Einstelleinrichtung (2) über den Antennenanschluß (31) oder einen Niederfrequenzanschluß (33) an das Funktelefon angelegt wird,
- ein Ausgangssignal (A, B) des Funktelefons, das durch das Anlegen des Testsignals erzeugt wurde, von der Einstelleinrichtung (2) über einen der Anschlüsse (31, 34) gemessen und die Einstellung mittels einer den Logikteil (10) enthaltenen Rückkopplungsschleife (2, 32, 1, 31; 2, 32, 1, 34) durchgeführt wird, bis der gewünschte Leistungspegel des Ausgangssignals (A, B) erreicht wird,
- die einzelnen Ergebnisse der Einstellung des Funktelefons als Kompensationskonstanten oder -werte in einem nichtflüchtigen Speicher des Logikteils (10) gespeichert werden,
- der Pegel und/oder die Abweichung des jeweiligen Ausgangssignals (A, B) mittels eines logisch gesteuerten Verstärkers (16, 17) geregelt und in Übereinstimmung mit den im Logikteil (10) gespeicherten Ergebnissen der Einstellung korrigiert wird, wenn sich das Funktelefon (1) im Betriebszustand befindet, und
- die Einstellung sequentiell für mehrere Kanäle oder Kanalbereiche und für einen oder mehrere Betriebstemperaturbereiche durchgeführt wird, wobei die Einstelleinrichtung Information über die Betriebsbedingungen des Funktelefons über den Logikteil (10) und den Anschluß für Zusatzgeräte (32) erhält, und wobei jedes Einstellergebnis als Kompensationswert im nichtflüchtigen Speicher des Logikteils (10) des Funktelefons gespeichert wird.

2. Verfahren nach Anspruch 1, **dadurch gekennzeichnet**, daß die Einstellung durchgeführt wird, ohne das Gehäuse des Funktelefons (1) zu öffnen.

3. Verfahren nach Anspruch 1 oder 2, **dadurch gekennzeichnet**, daß die Einstelleinrichtung (2) ein Meßgerät (21) zur Messung der einzustellenden Ausgangssignale (A, B) und einen Computer (20) mit einem gespeicherten Programm und gespeicherten Referenzwerten des Pegels und/oder der Abweichung des Ausgangssignals (A, B) enthält, auf deren Grundlage die Einstellung wahlweise automatisch oder halbautomatisch durchgeführt wird.

4. Verfahren zur Einstellung eines Funktelefons nach Anspruch 3 bei einer Serienfertigung, **dadurch gekennzeichnet**, daß der Computer (20) bei der Einstellung eines Funktelefons einer Serie die Langzeit Mittelwerte des Satzes von Kompensationswerten der vorher abgestimmten Funktelefone als ersten Satz von Kompensationswerten in den Logikteil (10) des Funktelefons eingibt.

5. Vorrichtung zur Einstellung eines Funktelefons, mit einem Funktelefon und einer externen Einstelleinrichtung, wobei das Funktelefon einen Antennenanschluß (31); einen ersten und einen zweiten Niederfrequenzanschluß (33, 34) sowie einen Zusatzanschluß (32) oder entsprechende Anschlüsse; einen Logikteil (10), der den Betrieb des Funktelefons steuert und einen nichtflüchtigen Speicher enthält; vom Logikteil (10) gesteuerte Verstärker (16, 17) zur jeweiligen Verstärkung der Signale des ersten Niederfrequenzanschlusses (33) und des Antennenanschlusses (31); und einen an den Logikteil angeschlossenen Sensor (14) zum Detektieren der Betriebsbedingungen des Funktelefons aufweist, wobei das Funktelefon so aufgebaut und angeordnet ist. daß über den ersten Niederfrequenzanschluß (33) oder den Antennenanschluß (31) angelegte Signale durch die Verstärker (16, 17) in Übereinstimmung mit den in dem nichtflüchtigen Speicher des Logikteils (10) gespeicherten Ergebnissen der Einstellung verstärkt werden, wobei die Abstimmung entsprechend einem Verfahren nach einem der vorhergehenden Ansprüche durchgeführt wurde, und wobei die externe Einstelleinrichtung an denAntennenanschluß, den Niederfrequenzanschluß, einen Zusatzanschluß oder entsprechende Anschlüsse des Funktelefons angeschlossen ist und folgendes enthält:
- eine Vorrichtung (21) zum Anlegen eines Testsignals über diese Anschlüsse an das Funktelefon und zum Messen eines Ausgangssignals des Funktelefons, das durch das angelegte Testsignal erzeugt wurde, und
- einen Meßcomputer (20) zur Einstellung des Ausgangssignals des Funktelefons mittels einer Rückkopplungsschleife über die Anschlüsse, bis ein gewünschter Leistungspegel des Ausgangssignals erreicht ist, und zur sequentiellen Auswahl mehrerer Kanäle oder Kanalbereiche und eines oder mehrerer Bertriebstemperaturbereiche des Funktelefons.

6. Vorrichtung nach Anspruch 5, **dadurch gekennzeichnet**, daß der Logikteil (10) des Funktelefons einen Mikroprozessor enthält.

7. Vorrichtung nach Anspruch 5 oder 6, **dadurch gekennzeichnet**, daß die Sensoren (10, 14) des Funktelefons, die die Betriebsbedingungen detektieren, eine Vorichtung (10) zum Detektieren des Betriebskanals oder Kanalbereichs und einen Temperatursensor (14) aufweisen.

8. Vorrichtung nach einem der Ansprüche 5 bis 7, **dadurch gekennzeichnet**, daß der logisch gesteuerte Verstärker (100; 16, 17) des Funktelefons einen Operationsverstärker (101), Rückkopplungswiderstände (102, 103, 107 - l09) und Analogschalter (104 - 106) enthält, die von dem Logikteil (10) gesteuert die Rückkopplungswiderstände (107 - 109) parallel in den Rückkopplungszweig schalten, um die gewünschte Verstärkung zu erzeugen.

## Revendications (Revendications pour l'(les) Etat(s) contractant(s) suivant(s): DK, LU, AT, ES, GR)

1. Procédé commandé par logique pour régler un radiotéléphone ayant une section logique (10) qui commande son fonctionnement, caractérisé en ce que :
- un équipement de réglage externe (2) est relié à l'interface (31) de l'antenne, à des interfaces basse fréquence (33, 34) et à une interface auxiliaire (32) ou à des interfaces correspondantes du radiotéléphone,
- un signal de test est appliqué à partir de l'équipement de réglage (2) via l'interface (31) de l'antenne ou une interface basse fréquence (33) au radiotéléphone,
- un signal de sortie (A, B) provenant du radiotéléphone et dû à l'application du signal de test est mesuré via l'une des interface (31, 34) par l'équipement de réglage (2) et un réglage est effectué dans une boucle de rétroaction (2, 32, 1, 31; 2, 32, 1, 34) via la section logique (10) jusqu'à ce que la valeur désirée de la puissance du signal de sortie (A, B) soit obtenue,
- les résultats du réglage individuel effectué pour le radiotéléphone sont stockés comme constantes ou valeurs de compensation dans une mémoire rémanente disposée dans la section logique (10),
- d'où il résulte que le signal respectif de sortie (A, B), la valeur et/ou la déviation sont commandés par l'intermédiaire de l'amplificateur commandé par logique (16, 17) corrigés en conformité avec les résultats du réglage stockés dans la section logique (10), lorsque le radiotéléphone (1) fonctionne.

2. Procédé selon la revendication 1, caractérisé en ce que le réglage peut être effectué sans ouvrir le boîtier du radiotéléphone (1).

3. Procédé selon la revendication 1 ou 2, caractérisé en ce que dans l'équipement de réglage (2) est disposé un dispositif de mesure (21) pour les signaux de sortie (A, B) à ajuster, et un ordinateur (20) avec un programme stocké et des valeurs cibles stockées pour le signal de sortie (A, B), la valeur et/ou la déviation, en conformité avec lesquels le réglage est exécuté, en option soit de manière automatique soit de manière semi-automatique.

4. Procédé selon l'une quelconque des revendications précédentes, dans lequel le réglage est fait séquentiellement pour plusieurs canaux ou gammes de canaux et pour une ou plusieurs gammes de températures de fonctionnement, d'où il résulte que l'équipement de réglage reçoit une information sur les conditions de fonctionnement du radiotéléphone par l'intermédiaire de la section logique (10) et de l'interface (32) de l'équipement auxiliaire et que le résultat de chaque réglage est stocké comme valeur de compensation dans la mémoire rémanente de la section logique (10) du radiotéléphone.

5. Mode opératoire pour régler des radiotéléphones dans une fabrication en série employant un procédé selon la revendication 3 ou 4 d'une façon telle que pendant le réglage d'un radiotéléphone de la série, l'ordinateur (20) fournit à la section logique (10) du radiotéléphone, comme première valeur de consigne, la valeur moyenne à long terme des valeurs de consigne correspondant aux résultats du réglage de téléphones accordés antérieurement.

6. Système de réglage pour un radiotéléphone comprenant un radiotéléphone et un équipement de réglage externe, ledit radiotéléphone comportant une interface d'antenne (31), des première et seconde interfaces basse fréquence (33, 34) et une interface auxiliaire (32) ou des interfaces correspondantes, une section logique (10) qui commande le fonctionnement du radiotéléphone, la section logique (10) comportant une mémoire rémanente, des amplificateurs (16, 17) commandés par la section logique (10) de manière à amplifier, respectivement, les signaux provenant de la première interface basse fréquence (33) et de l'interface (31) de l'antenne, et un capteur (14) détectant les conditions de fonctionnement du radiotéléphone connecté à la section logique (10), le radiotéléphone étant construit et agencé de façon que les signaux appliqués via la première interface basse fréquence (33) ou l'interface (31) de l'antenne soient amplifiés par les amplificateurs (16, 17) en conformité avec les résultats du réglage stockés dans la mémoire rémanente de la section logique (10), l'équipement de réglage externe étant connecté à l'interface d'antenne, à l'interface basse fréquence, à une interface auxiliaire ou à des interfaces correspondantes dudit radiotéléphone, et comportant :
- un dispositif (21) pour appliquer un signal de test au radiotéléphone via lesdites interfaces et pour mesurer un signal de sortie du radiotéléphone résultant de l'application dudit signal de test, et
- un ordinateur de mesure (20) pour ajuster ladite sortie du radiotéléphone dans une boucle de rétroaction via lesdites interfaces jusqu'à ce que la valeur désirée de la puissance dudit signal de sortie soit obtenue.

7. Système de réglage selon la revendication 6, dans lequel la section logique (10) du radiotéléphone comprend un microprocesseur.

8. Système de réglage selon la revendication 6 ou 7, dans lequel les capteurs (10, 14) du radiotéléphone détectant les conditions de fonctionnement comprennent un dispositif (10) détectant le canal ou la gamme des canaux de fonctionnement et un capteur de température (14).

9. Système de réglage selon l'une quelconque des revendications 6 à 8, dans lequel l'amplificateur commandé par logique (100; 16, 17) du radiotéléphone est constitué d'un amplificateur opérationnel (101), de résistances de rétroaction (102, 103, 107-109), de commutateurs analogiques (104-106), qui commandés par la section logique (10) mettent en parallèle les résistances de rétroaction (107-109) dans le trajet de rétroaction produisant l'amplification désirée.

## Revendications (Revendications pour l'(les) Etat(s) contractant(s) suivant(s): BE, CH, DE, FR, GB, IT, NL, SE)

1. Procédé commandé par logique pour régler un radiotéléphone ayant une section logique (10) qui commande son fonctionnement, caractérisé en ce que :
- un équipement de réglage externe (2) est relié à l'interface (31) de l'antenne, à des interfaces basse fréquence (33, 34) et à une interface auxiliaire (32) ou à des interfaces correspondantes du radiotéléphone,
- un signal de test est appliqué à partir de l'équipement de réglage (2) via l'interface (31) de l'antenne ou une interface basse fréquence (33) au radiotéléphone,
- un signal de sortie (A, B) provenant du radiotéléphone et dû à l'application du signal de test est mesuré via l'une des interface (31, 34) par l'équipement de réglage (2) et un réglage est effectué dans une boucle de rétroaction (2, 32, 1, 31; 2, 32, 1, 34) via la section logique (10) jusqu'à ce que la valeur désirée de la puissance du signal de sortie (A, B) soit obtenue,
- les résultats du réglage individuel effectué pour le radiotéléphone sont stockés comme constantes ou valeurs de compensation dans une mémoire rémanente disposée dans la section logique (10),
- d'où il résulte que le signal de sortie respectif (A, B), la valeur et/ou la déviation, sont commandés par l'intermédiaire de l'amplificateur commandé par logique (16, 17) corrigés en conformité avec les résultats du réglage stockés dans la section logique (10), lorsque le radiotéléphone (1) fonctionne et dans lequel le réglage est fait séquentiellement pour plusieurs canaux ou gammes de canaux et pour une ou plusieurs gammes de températures de fonctionnement, d'où il résulte que l'équipement de réglage reçoit une information sur les conditions de fonctionnement du radiotéléphone par l'intermédiaire de la section logique (10) et de l'interface (32) de l'équipement auxiliaire et d'où il résulte que chaque résultat de réglage est stocké comme valeur de compensation dans la mémoire rémanente de la section logique (10) du radiotéléphone.

2. Procédé selon la revendication 1, caractérisé en ce que le réglage peut être effectué sans ouvrir le boîtier du radiotéléphone (1).

3. Procédé selon la revendication 1 ou 2, caractérisé en ce que dans l'équipement de réglage (2) est disposé un dispositif de mesure (21) pour les signaux de sortie (A, B) devant être réglés et un ordinateur (20) avec un programme stocké et des valeurs cibles stockées pour le signal de sortie (A, B), la valeur et/ou la déviation, en conformité avec lesquels le réglage est exécuté, en option soit de manière automatique soit de manière semi-automatique.

4. Mode opératoire pour régler des radiotéléphones dans une production en série employant un procédé selon la revendication 3 d'une façon telle que, dans le réglage d'un radiotéléphone de la série, l'ordinateur (20) fournit à la section logique (10) du radiotéléphone, comme une première valeur de consigne, la valeur moyenne à long terme des valeurs de consigne correspondant aux résultats du réglage de téléphones accordés antérieurement.

5. Système de réglage pour un radiotéléphone comprenant un radiotéléphone et un équipement de réglage externe, ledit radiotéléphone comportant une interface d'antenne (31), des première et seconde interfaces basse fréquence (33, 34) et une interface auxiliaire (32) ou des interfaces correspondantes, une section logique (10) qui commande le fonctionnement du radiotéléphone, la section logique (10) ayant une mémoire rémanente, des amplificateurs (16, 17) commandés par la section logique (10) de manière à amplifier, respectivement, les signaux provenant de la première interface basse fréquence (33) et de l'interface (31) de l'antenne, et un capteur (14) détectant les conditions de fonctionnement du radiotéléphone connecté à la section logique (10), le radiotéléphone étant construit et agencé de façon que les signaux appliqués via la première interface basse fréquence (33) ou l'interface (31) de l'antenne soient amplifiés par les amplificateurs (16, 17) en conformité avec les résultats du réglage stockés dans la mémoire rémanente de la section logique (10) accordée en conformité avec le procédé de l'une quelconque des revendications précédentes, l'équipement de réglage externe étant connecté à l'interface d'antenne, à l'interface basse fréquence, à une interface auxiliaire et à des interfaces correspondantes dudit radiotéléphone, et comprenant :
- un dispositif (21) pour appliquer un signal de test au radiotéléphone via lesdites interfaces et pour mesurer un signal de sortie du radiotéléphone résultant de l'application dudit signal de test, et
- un ordinateur de mesure (20) pour ajuster ladite sortie du radiotéléphone dans une boucle de rétroaction via les interfaces jusqu'à ce que la valeur désirée de la puissance dudit signal de sortie soit obtenue et pour sélectionner séquentiellement plusieurs canaux ou gammes de canaux et une ou plusieurs gammes de température de fonctionnement du radiotéléphone.

6. Système de réglage selon la revendication 5, dans lequel la section logique (10) du radiotéléphone comprend un microordinateur.

7. Système de réglage selon la revendication 5 ou 6, dans lequel les capteurs (10, 14) du radiotéléphone détectant les conditions de fonctionnement comprennent un dispositif (10) détectant le canal ou la gamme de canaux de fonctionnement et un capteur de température (14).

8. Système de réglage selon l'une quelconque des revendications 5 à 7, dans lequel l'amplificateur commandé par logique (100; 16, 17) du radiotéléphone est constitué d'un amplificateur opérationnel (101), de résistances de rétroaction (102, 103, 107-109), de commutateurs analogiques (104-106), qui commandés par la section logique (10) connectent en parallèle les résistances de rétroaction (107-109) dans le trajet de rétroaction produisant l'amplification désirée.
